# EUROPEAN PATENT SPECIFICATION

(11) **EP 3 995 607 B1**
(45) Date of publication and mention of the grant of the patent: **16.09.2026**
(21) Application number: 20836821.7
(22) Date of filing: 06.04.2020
(51) Int. Cl.: C30B 29/06, C30B 13/20, H05B 6/36

(54) **INDUCTION-HEATING COIL AND SINGLE CRYSTAL PRODUCTION DEVICE USING SAME**
INDUKTIONSHEIZSPULE UND VORRICHTUNG ZUR HERSTELLUNG VON EINKRISTALLEN DAMIT
BOBINE DE CHAUFFAGE PAR INDUCTION ET DISPOSITIF DE PRODUCTION DE MONOCRISTAUX L'UTILISANT

(30) Priority: 05.07.2019 JP 2019126098
(43) Date of publication of application: 11.05.2022
(73) Proprietor: SUMCO Corporation, Minato-ku Tokyo 105-8634 (JP)
(72) Inventor: MATSUSHIMA, Naoki, Tokyo 105-8634 (JP); YOKOYAMA, Ryusuke, Tokyo 105-8634 (JP)
(74) Representative: Kraus & Lederer PartGmbB
(86) International application number: PCT/JP2020/015452
(87) International publication number: WO 2021/005853

(56) References cited:
- CN-A- 108 179 462
- JP-A- 2006 169 060
- JP-A- 2012 224 522
- JP-A- 2013 168 345
- JP-A- H01 131 094
- JP-A- H07 130 460
- US-A- 4 579 719
- US-A- 4 942 279
- US-A- 5 792 258

## Description

### [Technical Field]

The present invention relates to an induction heating coil used for manufacturing a single crystal using an FZ (Floating Zone) method and a single crystal manufacturing apparatus using the same.

### [Background Art]

An FZ method is known as one of the methods of growing a silicon single crystal. In the FZ method, a part of a polycrystalline raw material rod is heated to form a molten zone, and the raw material rod and a single crystal positioned respectively above and below the molten zone are slowly lowered to gradually grow the single crystal. The FZ method does not use a crucible for supporting a melt, so that the quality of a silicon single crystal to be obtained is not affected by the crucible, thereby allowing the growth of a single crystal of higher purity than that obtained using a CZ method.

An induction heating coil can be used to heat the raw material rod. For example, JP 50-037346A describes that an induction heating coil composed of a metal tube of at least two turns is coated with a heat-resistant insulating material on the surface of the outermost turn so as to prevent a flashover. Further, JP 2006-169060A describes that a coating of an insulating material is formed on a part of or the entire surface of an induction heating coil so as to prevent a discharge between any one of a polycrystalline raw material rod, a single crystal rod, and a molten zone, and the induction heating coil.

JP 2013-168345A describes an induction heating coil having a flat part provided on the coil rear surface at a position within a range of 20° or more and 80° or less around a slit and a taper part which becomes thicker from the inner peripheral direction to the outer peripheral direction and is provided on the coil rear surface at a range except the flat part. Further, JP 2015-043262A describes that the surface of an induction heating coil is coated with a reflecting film having high reflectance with respect to an electromagnetic wave in an infrared wavelength region to suppress an energy loss caused by heat dissipation from a heated member to a heater including the coil and the ambient air. Furthermore, JP 2012-101980A describes an induction heating coil having a cooling water channel through which cooling water flows and which is formed with a coating film for preventing oxidation.

US 4 942 279 A discloses an induction heating coil according to the preamble of claim 1. Further induction heating coils and growth methods are known from US 4 579 719 A, US 5 792 258 A and CN 108 179 462 A.

### [Disclosure of the Invention]

### [Problem to be Solved by the Invention]

In the manufacture of a silicon single crystal using the FZ method, the uniformity of in-plane resistivity distribution is a key technical challenge. To suppress a variation in the in-plane resistivity distribution in a silicon single crystal, it is necessary to adjust convection due to temperature distribution in the molten zone and a way to melt a silicon raw material, and so far, a method of changing the shape of the induction heating coil has been taken. However, changing the coil shape involves a change in the distribution of electromagnetic force generated from the coil, which may cause such unwanted effects that the molten zone is apt to spill out.

It is therefore an object of the present invention to provide an induction heating coil capable of making the resistivity distribution in a single crystal as uniform as possible by adjusting temperature distribution in the molten zone and raw material rod without changing the coil shape and a single crystal manufacturing apparatus using such an induction heating coil.

### [Means for Solving the Problem]

An induction heating coil as defined in claim 1, a silicon single crystal manufacturing apparatus as defined in claim 17 and a manufacturing method as defined in claim 18 are provided. The dependent claims define further embodiments.

To solve the above problem, an induction heating coil according to the present invention is an induction heating coil used for manufacturing a silicon single crystal using an FZ method and includes: a coil conductor formed of a substantially ring-shaped conductor plate; and a pair of terminal electrodes provided at one end and the other end of the coil conductor so as to be adjacent in the circumferential direction of the coil conductor. The coil conductor has an opening formed at the center portion thereof and a slit that radially extends from the opening to circumferentially separate connection positions of the pair of terminal electrodes from each other. At least the lower surface of the coil conductor is sectioned into a plurality of areas, and the plurality of areas have different emissivities.

According to the present invention, it is possible to adjust temperature distribution in a molten zone and a raw material rod without changing the shape of the induction heating coil. This makes it possible to reduce a variation in the in-plane resistivity distribution in the single crystal grown using the FZ method.

In the present invention, the coil conductor is preferably radially sectioned into the plurality of areas. In this case, the lower surface of the coil conductor preferably has an inner circumferential area adjacent to the opening, an intermediate area positioned radially outside the inner circumferential area, and an outer circumferential area positioned radially outside the intermediate area. This can reduce a variation in the in-plane resistivity distribution in the single crystal.

Assuming that the radius of the raw material rod is R, it is preferable that the radius of the coil conductor be 1.5R or more, the inner circumferential area be an area of less than 0.8R from the coil center in the radial direction, the intermediate area be an area of 0.8R or more and less than 1.2R from the coil center in the radial direction and the outer circumferential area be an area of 1.2R or more from the coil center in the radial direction. This can reduce a variation in the in-plane resistivity distribution in the single crystal.

In the present invention, the emissivity of the intermediate area is preferably higher than those of the inner circumferential area and outer circumferential area. A silicon single crystal manufactured using the FZ method is likely to have a high resistivity at the outer circumferential portion thereof. Thus, by increasing the emissivity of the intermediate area of the lower surface of the coil conductor that is close to the outer circumferential portion of the molten zone to enhance a heat removal effect, it is possible to reduce the resistivity at the outer circumferential portion of the single crystal.

In the present invention, the emissivity of the inner circumferential area is preferably equal to or higher than that of the outer circumferential area. By making the emissivity of the inner circumferential area of the coil conductor higher than that of the outer circumferential area, it is possible to suppress a reduction in the resistivity at the center position of the single crystal.

It is preferable that the emissivity of the inner circumferential area be 0.03 or more and 0.3 or less, the emissivity of the intermediate area be 0.5 or more and 0.8 or less and the emissivity of the outer circumferential area be 0.03 or more and 0.1 or less. This makes the in-plane resistivity distribution in the single crystal as uniform as possible.

The coil conductor is preferably circumferentially sectioned into the plurality of areas. This can reduce the influence that the slit has on the emissivity distribution in the induction heating coil, making the emissivity distribution in the circumferential direction as uniform as possible.

The inner circumferential area preferably has a first inner circumferential area adjacent to the slit and a second inner circumferential area further away from the slit than the first inner circumferential area. The intermediate area preferably has a first intermediate area adjacent to the slit and a second intermediate area further away from the slit than the first intermediate area.

It is preferable that the first inner circumferential area be an area within an angle range of 20° or more and 80° or less around the slit and the second inner circumferential area be an area obtained by excluding the first inner circumferential area from the inner circumferential area. Further, it is preferable that the first intermediate area be an area within an angle range of 20° or more and 80° or less around the slit and the second intermediate area be an area obtained by excluding the first intermediate area from the intermediate area.

It is preferable that the emissivity of the second inner circumferential area is equal to or higher than that of the first inner circumferential area and the emissivity of the first intermediate area is higher than that of the second intermediate area.

It is preferable that the emissivity of the first inner circumferential area is 0.03 or more and 0.1 or less and the emissivity of the second inner circumferential area is 0.03 or more and 0.3 or less. Further, it is preferable that the emissivity of the first intermediate area is 0.6 or more and 0.8 or less, and the emissivity of the second intermediate area is 0.5 or more and less than 0.6. By breaking the circumferential symmetry of the emissivity, a stirring effect for the molten zone can be improved. This makes it possible to manufacture a single crystal whose in-plane resistivity distribution is made as uniform as possible.

It is preferable that the lower surface of the coil conductor form a slope inclined upward toward the coil center and the upper surface of the coil conductor form a slope inclined downward toward the coil center. With this configuration, adequate electromagnetic pressure can be applied to the molten zone, whereby the molten zone can be stably held on the silicon single crystal.

It is preferable that the emissivity is set by changing the surface roughness of the coil conductor. This allows the emissivity to be adjusted for each area without changing the coil shape.

It is preferable that the emissivity is preferably set by forming a coating to cover the surface of the coil conductor. This allows the emissivity to be adjusted for each area without changing the coil shape.

A silicon single crystal manufacturing apparatus according to the present invention includes: a reaction furnace accommodating a raw material rod and a silicon single crystal grown on a seed crystal; an upper shaft that rotatably and vertically movably supports the raw material rod; a lower shaft that rotatably and vertically movably supports the seed crystal; the above-described induction heating coil according to the present invention that heats the lower end portion of the raw material rod to form a molten zone.

According to the present invention, it is possible to improve, using an FZ method, the manufacturing yield of the single crystal in which the in-plane resistivity distribution is made as uniform as possible.

Further, an induction heating coil design method according to the present invention is a method of designing an induction heating coil used for manufacturing a single crystal using an FZ method and includes dividing at least the lower surface of a coil conductor formed of a substantially ring-shaped conductor plate into a plurality of areas having different emissivities.

According to the present invention, it is possible to improve, using an FZ method, the manufacturing yield of the single crystal in which the in-plane resistivity distribution is made as uniform as possible.

### [Advantageous Effects of the Invention]

According to the present invention, there can be provided an induction heating coil capable of making the resistivity distribution in the single crystal as uniform as possible by adjusting temperature distribution in the molten zone and raw material rod without changing the coil shape and a single crystal manufacturing apparatus using such an induction heating coil.

### [Brief Description of the Drawings]

[FIG. 1] FIG. 1 is a cross-sectional side view schematically illustrating the configuration of a single crystal manufacturing apparatus according to the embodiment of the present invention.
[FIG. 2] FIG. 2 is a schematic perspective view illustrating the configuration of the induction heating coil.
[FIG. 3] FIGS. 3A and 3B are plan views each illustrating an example of a plurality of division areas of the induction heating coil for which the emissivities are defined independently of one another.
[FIG. 4] FIG. 4 is a schematic view for explaining a path for current flowing in the induction heating coil.
[FIG. 5] FIG. 5 is a schematic cross-sectional side view illustrating the positional relation between the molten zone and the induction heating coil.
[FIG. 6] FIG. 6 is a plan view illustrating a setting example of emissivity distribution on the lower surface side of the induction heating coil.
[FIG. 7] FIG. 7 is a plan view illustrating a setting example of emissivity distribution on the upper surface side of the induction heating coil.
[FIG. 8] FIG. 8 is a plan view illustrating another example of a plurality of division areas of the induction heating coil.
[FIG. 9] FIG. 9 is a plan view illustrating an emissivity distribution of the induction heating coil according to Example 1.
[FIG.10] FIG. 10 is a graph illustrating the resistivity distribution in the silicon wafers produced by FZ method with the induction heating coil according to Example 2 in comparison with the conventional one.
[FIG. 11] FIG. 11 is a plan view illustrating an emissivity distribution of the induction heating coil according to Example 2.
[FIG. 12] FIG. 12 is a graph illustrating the resistivity distribution in the silicon wafers produced by FZ method with the induction heating coil according to Example 2 in comparison with the conventional one.

### [Mode for Carrying Out the Invention]

A preferred embodiment of the present invention will be described in detail below with reference to the accompanying drawings.

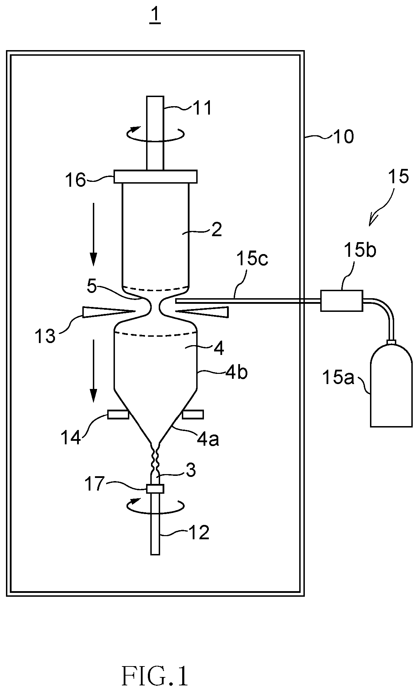

FIG. 1 is a cross-sectional side view schematically illustrating the configuration of a single crystal manufacturing apparatus according to the embodiment of the present invention.

As illustrated in FIG. 1, a single crystal manufacturing apparatus 1 is an apparatus for growing a silicon single crystal using the FZ method. The single crystal manufacturing apparatus 1 includes a reaction furnace 10 accommodating a raw material rod 2 and a silicon single crystal 4 to be grown on a seed crystal 3, an upper shaft 11 that rotatably and vertically movably supports the raw material rod 2, a lower shaft 12 that rotatably and vertically movably supports the seed crystal 3 and silicon single crystal 4, an induction heating coil 13 for heating the lower end portion of the raw material rod 2, a single crystal weight supporter 14 for supporting the weight of the silicon single crystal 4 grown in size due to advance in crystal growth, and a gas doping apparatus 15 for supplying a dopant gas to a molten zone 5 (silicon melt) between the raw material rod 2 and the silicon single crystal 4.

The raw material rod 2 is made from high-purity polycrystalline silicon obtained by purifying a silicon source material such as monosilane and the upper end portion of the raw material rod 2 is attached to the lower end portion of the upper shaft 11 through a raw material holder 16. The lower end portion of the seed crystal 3 is attached to the upper end portion of the lower shaft through a seed crystal holder 17. The upper and lower shafts 11 and 12 are each rotated and vertically moved by a not-shown drive mechanism.

The induction heating coil 13 is a high-frequency coil of substantially one turn that surrounds the raw material rod 2 or molten zone 5 and is connected to a not-shown AC power source. The induction heating coil 13 is preferably made of copper or silver. By applying a high-frequency voltage to the induction heating coil 13, a part of the raw material rod 2 is inductively heated to thereby produce the molten zone 5. The raw material rod 2 is preferably pre-heated before being heated by the induction heating coil 13. The seed crystal 3 is fused to the thus produced molten zone 5, and then the raw material rod 2 and silicon single crystal 4 are lowered while being rotated, whereby the silicon single crystal 4 can be grown from the molten zone 5.

The single crystal weight supporter 14 comes into contact with a tapered section 4a of the silicon single crystal 4 to hold the silicon single crystal 4. The single crystal weight supporter 14 receives a large part of the weight of the silicon single crystal 4, whereby the weight of the silicon single crystal 4 hardly acts on the seed crystal 3.

The gas doping apparatus 15 includes a gas cylinder 15a accommodating a highly-pressurized dopant gas, a flow rate controller 15b for controlling the flow rate of the dopant gas, and a gas nozzle 15c for spraying the dopant gas to the molten zone 5. The amount of the dopant to be supplied to the molten zone 5 is adjusted by changing the flow rate of the dopant gas. To stably control the amount of the dopant to be supplied, it is preferable to adjust only the flow rate of the dopant gas with the concentration thereof kept constant.

The raw material rod 2 installed above the silicon single crystal 4 is melted by induction heating, and the silicon melt is held at the upper portion of the silicon single crystal 4. The silicon melt is heated by the induction heating coil 13 and held by electromagnetic force generated from the induction heating coil 13. The air-liquid interface shape of the silicon melt is determined based on the balance among gravity, surface tension, pressure difference between the inside and outside of the melt, and electromagnetic force.

Resistivity distribution is one of the important quality characteristics required for the silicon single crystal 4 to be grown using the FZ method. The dopant is supplied to the molten zone 5 by, for example, spraying the dopant gas to the molten zone 5. Thus, to reduce a variation in the resistivity distribution, the molten zone 5 needs to be stirred well. The molten zone 5 is stirred by forced convection by crystal rotation, as well as, by heat convection resulting from the temperature distribution in the molten zone 5.

As a solution to improve the resistivity distribution in the silicon single crystal 4, there is an available method of changing the shape of the induction heating coil 13. By changing the coil shape, it is possible to change temperature distribution to thereby change heat convection. However, in this method, an unintentional change may occur in the silicon melt. Since the silicon melt is held by electromagnetic force as described above, a change in the coil shape causes a change in the distribution of the electromagnetic force, which in turn affects melt convection and air-liquid interface shape. This causes an unintentional change to occur in the silicon melt, and in the worst case, the silicon melt cannot be held.

In the present embodiment in which not the electromagnetic field distribution, but the temperature distribution is changed, the surface of the induction heating coil 13 is sectioned into a plurality of areas, and infrared emissivities of the areas are set independently of one another, whereby the infrared emissivity on the surface of the induction heating coil 13 can be partially changed.

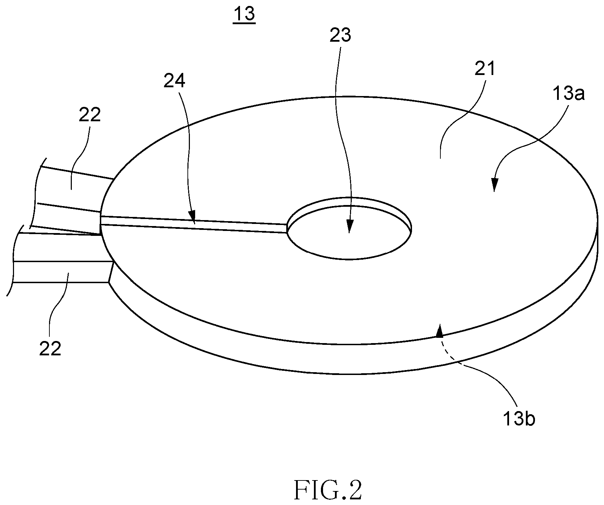

FIG. 2 is a schematic perspective view illustrating the configuration of the induction heating coil 13.

As illustrated in FIG. 2, the induction heating coil 13 has a coil conductor 21 formed of a substantially ring-shaped conductor plate and a pair of terminal electrodes 22, 22 for applying a high-frequency voltage to the coil conductor 21.

The coil conductor 21 has a configuration in which an opening 23 at the center portion of a disk-shaped conductor, and a slit 24 radially extends from the opening 23 to circumferentially divide the ring-shaped conductor at one portion. The slit 24 is formed between the pair of terminal electrodes 22, 22 adjacent to each other in the circumferential direction to circumferentially separate connection positions of the pair of terminal electrodes 22, 22 from each other. The outer diameter of the coil conductor 21 is larger than the diameters of the raw material rod 2 and the silicon single crystal 4 (straight body section 4b), and the inner diameter of the coil conductor 21 (the diameter of the opening 23) is smaller than the diameters of the raw material rod 2 and the silicon single crystal 4.

An upper surface 13a of the induction heating coil 13 preferably forms a slope inclined downward from the outer circumferential end toward the center (the opening 23), and a lower surface 13b of the induction heating coil 13 preferably forms a slope inclined upward from the outer circumferential end toward the center. That is, the induction heating coil 13 preferably has a tapered cross-sectional shape gradually reduced in thickness from the outer circumferential end to the inner circumferential end. In this case, the inclination angle of the upper surface 13a and that of the lower surface 13b may be the same or different. When the induction heating coil 13 has such a shape, adequate electromagnetic pressure and adequate radiant heat can be applied to the molten zone 5 and raw material rod 2, whereby the molten zone 5 can be stably held on the silicon single crystal 4.

The induction heating coil 13 may have a water-cooling structure. That is, a flow channel of cooling water may be provided inside the coil conductor 21. This can suppress the consumption of the induction heating coil 13.

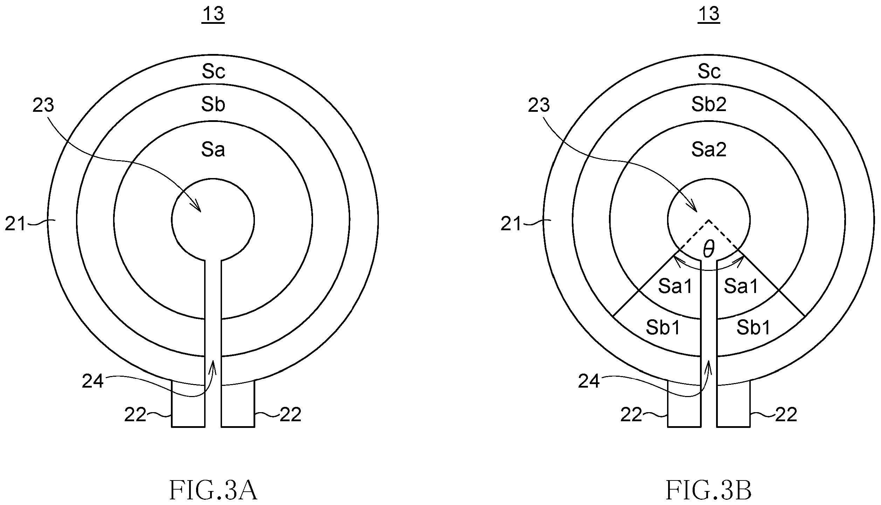

FIGS. 3A and 3B are plan views each illustrating an example of a plurality of division areas of the induction heating coil 13 for which the emissivities are defined independently of one another.

As illustrated in FIG. 3A, the upper and lower surfaces 13a and 13b of the induction heating coil 13 can be radially sectioned into three areas based on the influence that the radiant heat of the induction heating coil 13 has on the surroundings. Specifically, the three areas include an inner circumferential area Sa close to the coil center, an intermediate area Sb which is positioned outside the inner circumferential area Sa and the distance of which from the coil center is close to the radius of the raw material rod 2 or the radius of the silicon single crystal 4, and an outer circumferential area Sc which is positioned outside the intermediate area Sb and the distance of which from the coil center is larger than the radius of the raw material rod 2 or the radius of the silicon single crystal 4.

Assuming that the radius of the raw material rod 2 is R, it is preferable that the inner circumferential area Sa be an area of less than 0.8R from the coil center in the radial direction, the intermediate area Sb be an area of 0.8R or more and less than 1.2R from the coil center in the radial direction and the outer circumferential area Sc be an area of 1.2R or more from the coil center in the radial direction. The outer circumferential radius of the coil conductor 21 is preferably 1.5R or more.

Further, as illustrated in FIG. 3B, the inner circumferential area Sa and the intermediate area Sb can be each circumferentially sectioned into two areas. Specifically, the inner circumferential area Sa can be sectioned into a first inner circumferential area Sa1 positioned close to the slit 24 and a second inner circumferential area Sa2 positioned further away from the slit 24 than the first inner circumferential area Sa1. The intermediate area Sb can be sectioned into a first intermediate area Sb1 positioned close to the slit 24 and a second intermediate area Sb2 positioned away from the slit 24.

The first inner circumferential area Sa1 is an area within an angle θ around the slit 24, and the second inner circumferential area Sa2 is an area obtained by excluding the first inner circumferential area Sa1 from the inner circumferential area Sa. Similarly, the first intermediate area Sb1 is an area within the angle θ around the slit 24, and the second intermediate area Sb2 is an area obtained by excluding the first intermediate area Sb1 from the intermediate area Sb. The angle θ is preferably 20° or more and 80° or less.

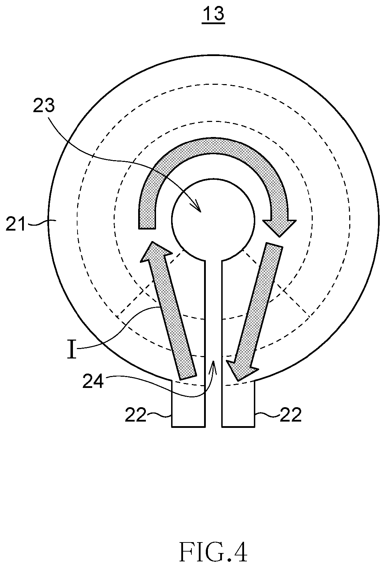

FIG. 4 is a schematic view for explaining a path for current flowing in the induction heating coil 13.

As illustrated in FIG. 4, current I flows in a path that makes the distance between the pair of terminal electrodes 22, 22 of the induction heating coil 13 the shortest. Thus, the first inner circumferential area Sa1 has a low current density, so that the center portion of the molten zone 5 close to this area has a small heat generation amount. The first intermediate area Sb1 close to the pair of terminal electrodes 22, 22 has a high current density, so that the outer circumferential potion of the molten zone 5 close to this area has a large heat generation amount.

The second inner circumferential area Sa2 and second intermediate area Sb2 have the same heat generation distribution as the axially symmetric induction heating coil 13 that does not have the slit 24. The second inner circumferential area Sa2 has a high current density, so that the center portion of the molten zone 5 close to this area has a large heat generation amount. The second intermediate area Sb2 has a low current density, and thus the outer circumferential portion of the molten zone 5 close to this area has a small heat generation amount. Further, the outer circumferential area Sc has a low current density and positioned away from the molten zone 5 and thus has a little influence on the heat generation distribution in the molten zone 5.

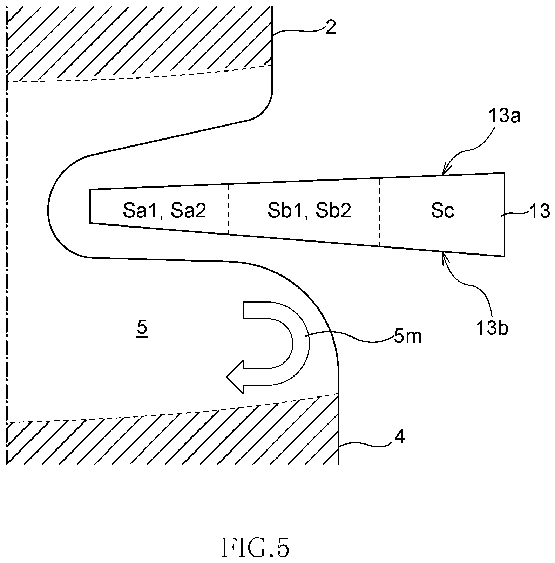

FIG. 5 is a schematic cross-sectional side view illustrating the positional relation between the molten zone 5 and the induction heating coil 13.

As illustrated in FIG. 5, the upper surfaces of the first intermediate area Sb1 and second intermediate area Sb2 of the induction heating coil 13 are away from the raw material rod 2, so that a part of the raw material rod 2 that is close to the first intermediate area Sb1 and second intermediate area Sb2 has a small heat generation amount. On the other hand, the distance between the lower surfaces of the first intermediate area Sb1 and second intermediate area Sb2 and the molten zone 5 is comparatively small, so that the outer circumferential portion of the molten zone 5 close to the first intermediate area Sb1 and second intermediate area Sb2 has a large heat generation amount.

The outer circumferential area Sc is away from the raw material rod 2 and molten zone 5 and thus has a little influence on the heat generation distribution. However, the emissivity of the outer circumferential area Sc is involved in the heat-retaining properties of the raw material rod 2 and molten zone 5, which is not negligible and hence is preferably as low as possible.

A silicon wafer manufactured using the FZ method is likely to have a large variation in the resistivity at the outer circumferential portion thereof, and reducing a variation in the resistivity at the outer circumferential portion is a challenge with respect to quality aspect. It is considered that the reason why the variation of the resistivity becomes large at the wafer outer circumferential portion is that, as illustrated, Marangoni convection 5m is generated at the outer circumferential portion of the molten zone 5.

The Marangoni convection 5m is melt convection resulting from the temperature distribution on the surface of the molten zone 5. At the outer circumferential portion of the molten zone 5, a stirring effect by crystal rotation and a stirring effect by the Marangoni convection conflict with each other to suppress the melt convection and thus to reduce stirring force, with the result that the dopant concentration at the outer circumferential portion is likely to vary. In the present embodiment, heat is removed from the outer circumferential position of the molten zone 5 to suppress the Marangoni convection so as to increase the stirring effect by the rotation, whereby a radial variation in the dopant concentration can be suppressed.

Contrary to the outer circumferential portion, the center portion of a silicon wafer is likely to have a low resistivity. This is because the stirring effect by the crystal rotation is small at the center portion of the molten zone 5. In the present embodiment, the emissivities of the first and second inner circumferential areas Sa1 and Sa2 on the lower surface 13b of the induction heating coil 13 are relatively reduced to adjust the temperature distribution at the center portion of the molten zone 5. This generates such melt convection as to span the center of the crystal rotation to thereby increase the stirring effect.

In the course of melting the raw material rod 2 by means of the induction heating coil 13, the melting becomes unstable due to the asymmetry of the coil shape to cause problems such as biased melting and generation of icicle-like unmelted residues which may undesirably contact the induction heating coil 13. Thus, it is important to make the temperature distribution on the melt surface of the silicon raw material as uniform as possible to achieve stable melting. Therefore, it is preferable in the lower surface 13b of the induction heating coil 13 that the emissivities of the first intermediate area Sb1 and the second inner circumferential area Sa2 with a large current amount be increased, while the emissivities of the first inner circumferential area Sa1 and the second intermediate area Sb2 with a small current amount be reduced.

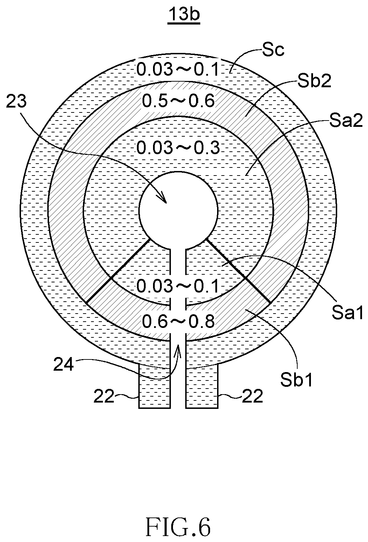

FIG. 6 is a plan view illustrating a setting example of emissivity distribution on the lower surface 13b side of the induction heating coil 13.

As illustrated in FIG. 6, for the lower surface 13b of the induction heating coil 13, the emissivity of the inner circumferential area Sa is preferably set to 0.03 or more and 0.3 or less, the emissivity of the intermediate area Sb is preferably set to 0.5 or more and 0.8 or less, and the emissivity of the outer circumferential area Sc is preferably set to 0.03 or more and 0.1 or less. Further, the emissivity of the first inner circumferential area Sa1 is preferably set to 0.03 or more and 0.1 or less, the emissivity of the second inner circumferential area Sa2 is preferably set to 0.03 or more and 0.3 or less. Further, the emissivity of the first intermediate area Sb1 is preferably set to 0.6 or more and 0.8 or less, and the emissivity of the second intermediate area Sb2 is preferably set to 0.5 or more and less than 0.6.

To change the emissivity of the surface of the induction heating coil 13, there are available methods of changing surface roughness and of forming a coating on the surface, although not particularly limited thereto. When the emissivity is changed by changing the surface roughness, the larger the surface roughness is, the higher the emissivity becomes. It follows that when being mirror-finished, the surface of the induction heating coil 13 has a reduced emissivity.

A coating to be formed on the surface of the induction heating coil 13 may be conductive or insulative but needs to have high-temperature resistance. Examples of the insulative coating include aluminum oxide, silicon nitride, polytetrafluoroethylene, silicon oxide, amorphous diamond, and the like. These coatings can be formed by a CVD method or a PVD method. The conductive coating can be formed by metal plating. Examples of the metal to be used include chromium, nickel, zinc, tin, gold, and an alloy containing them. The color of the coating can be changed depending on the plating method. Further, by changing the surface roughness of the formed coating, the emissivity can be finely adjusted.

The emissivity of the surface of the induction heating coil 13 can be changed from 0.02 to 0.9. For example, the emissivity of the surface of well-polished copper or silver is 0.02, and the emissivity of a black plated surface is 0.9.

The emissivity distribution on the upper surface 13a of the induction heating coil 13 may be the same as or different from the emissivity distribution on the lower surface 13b. The emissivity distribution on the upper surface 13a of the induction heating coil 13 is set for the purpose of stably and uniformly melting the raw material rod 2. The stable and uniform melting of the raw material rod 2 can also suppress a variation in the dopant concentration in the melt. When the emissivity distribution on the upper surface 13a of the induction heating coil 13 is made different from that of the lower surface 13b, the emissivities of the areas on the upper surface 13a may be set independently of one another as with the lower surface 13b, or the same emissivity may be set for all the plurality of areas. The temperature distribution on the upper surface 13a of the induction heating coil 13 has influence on the melting behavior of the raw material rod 2, so that by breaking the circumferential symmetry of the emissivity, a stirring effect for the molten zone can be improved.

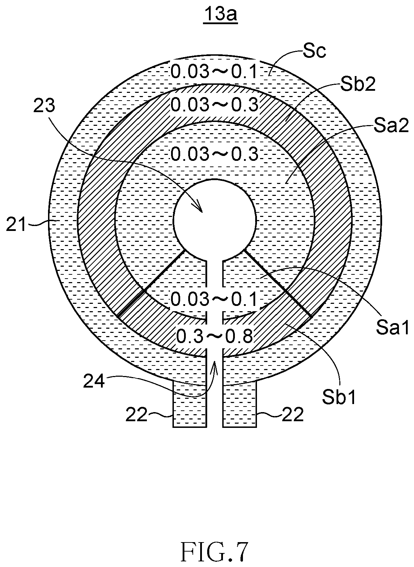

FIG. 7 is a plan view illustrating a setting example of emissivity distribution on the upper surface 13a side of the induction heating coil 13.

As illustrated in FIG. 7, for the upper surface 13a of the induction heating coil 13, the emissivity of the inner circumferential area Sa is preferably set to 0.03 or more and 0.3 or less, the emissivity of the intermediate area Sb is preferably set to 0.03 or more and 0.8 or less, and the emissivity of the outer circumferential area Sc is preferably set to 0.03 or more and 0.1 or less. Further, the emissivity of the first inner circumferential area Sa1 is preferably set to 0.03 or more and 0.1 or less, the emissivity of the second inner circumferential area Sa2 is preferably set to 0.03 or more and 0.3 or less. Further, the emissivity of the first intermediate area Sb1 is preferably set to 0.3 or more and 0.8 or less, and the emissivity of the second intermediate area Sb2 is preferably set to 0.03 or more and 0.3 or less.

As described above, in the present embodiment, at least the lower surface 13b of the induction heating coil 13 is sectioned into a plurality of areas having different emissivities, so that it is possible to adjust the molten zone 5 and raw material rod 2 in terms of temperature distribution without changing the coil shape. This can make the in-plane resistivity distribution in the silicon single crystal as uniform as possible.

In the above embodiment, the induction heating coil 13 is radially sectioned into three areas, and the inner circumferential area Sa and the intermediate area Sb are each sectioned into two areas, thereby obtaining five areas in total. However, the dividing method is not particularly limited, and the induction heating coil 13 may be sectioned in any manner.

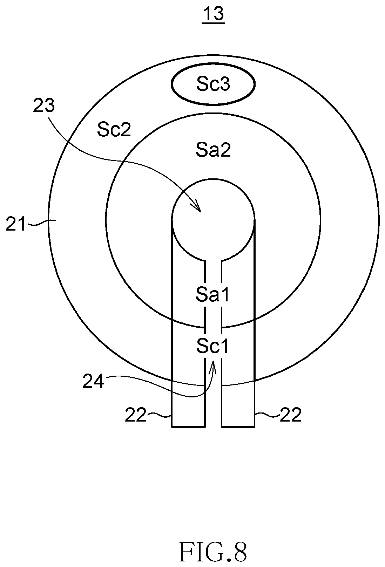

FIG. 8 is a plan view illustrating another example of a plurality of division areas of the induction heating coil 13 for which the emissivities are defined independently of one another.

As illustrated in FIG. 8, the upper and lower surfaces 13a and 13b of the induction heating coil 13 are each sectioned into a first inner circumferential area Sa1 close to both the coil center and slit 24, a second inner circumferential area Sa2 closed to the coil center and away from the slit 24, a first outer circumferential area Sc1 away from the coil center and close to the slit 24, a second outer circumferential area Sc2 away from both the coil center and slit 24, and a third outer circumferential area Sc3 away from the coil center and further away from the slit 24 than the second outer circumferential area Sc2. The first inner circumferential area Sa1 and first outer circumferential area Sc1 within the slit vicinity area are each defined not by the angle θ around the slit but by the diameter of the opening 23 in the width direction of the slit and set inside the diameter of the opening 23. The third outer circumferential area Sc3 is formed on the side opposite the first outer circumferential area Sc1 with respect to the opening 23.

Although the division form of the induction heating coil 13 according to this embodiment slightly differs from those illustrated in FIGS. 3A and 3B as described above, it is possible to independently define the emissivity of the induction heating coil 13 for each area. This makes it possible to adjust the temperature distribution in the molten zone 5 and raw material rod 2 without changing the coil shape, thereby making the in-plane resistivity distribution in the silicon single crystal as uniform as possible.

While the preferred embodiments of the present invention have been described above, the present invention is not limited to the above embodiments, and various modifications may be made within the scope of the present invention, and all such modifications are included in the present invention.

For example, although the FZ method has been taken as an example of the manufacturing method for a silicon single crystal in the above embodiment, the induction heating coil according to the present invention is not limitedly applied to the manufacture of a silicon single crystal but is applicable to the manufacture of various single crystals. Further, although the method of changing the surface roughness and the method of forming a coating have been taken as a method for changing the emissivity, the emissivity can be changed by other methods.

Further, the gas doping apparatus 15 is used to supply a dopant gas to the molten zone 5 for doping a silicon single crystal in the above embodiment, the raw material rod 2 may be doped in advance.

Further, in the above embodiment, the surface on the induction heating coil is concentrically sectioned into a plurality of areas and circumferentially sectioned into the slit vicinity area and other areas; alternatively, however, the surface on the induction heating coil may be radially sectioned in the circumferential direction or may be sectioned in a lattice pattern. Further, the above dividing methods may be combined.

### [Examples]

### <Example 1>

The lower surface 13b of the induction heating coil 13 was sectioned into five areas as described above, and the obtained areas were defined as follows. First, the first inner circumferential area Sa1 was set as an area of less than 0.8R (R is the radius of the raw material rod) from the coil center and within an angle θ around the slit 24, the second inner circumferential area Sa2 was set as an area of less than 0.8R from the coil center and outside the angle θ around the slit 24. The first intermediate area Sb1 was set as an area of equal to or more than 0.8R and less than 1.2R from the coil center and within the angle θ around the slit 24, and the second intermediate area Sb2 was set as an area of equal to or more than 0.8R and less than 1.2R from the coil center and outside the angle θ around the slit 24. The outer circumferential area Sc was set as an area of equal to or more than 1.2R from the coil center.

Then, to improve the resistivity distribution at the wafer outer circumferential portion, the emissivities of the five areas on the lower surface 13b of the induction heating coil 13 were set as follows. That is, heat was removed from the first and second intermediate area Sb1 and Sb2 having a large heat generation amount so as to lower the temperature at the outer peripheral portion of the molten zone 5. The heat generation amount from the first intermediate area Sb1 which is close to the slit 24 was large, so that the emissivity of the first intermediate area Sb1 was made higher than that of the second intermediate area Sb2. Further, the first inner circumferential area Sa1 had a smaller heat generation amount than that of the second inner circumferential area Sa2, so that the emissivity of the first inner circumferential area Sa1 was reduced to enhance a heat-retaining property. Similarly, the emissivity of the outer circumferential area Sc was reduced so as not to lose a heat-retaining property.

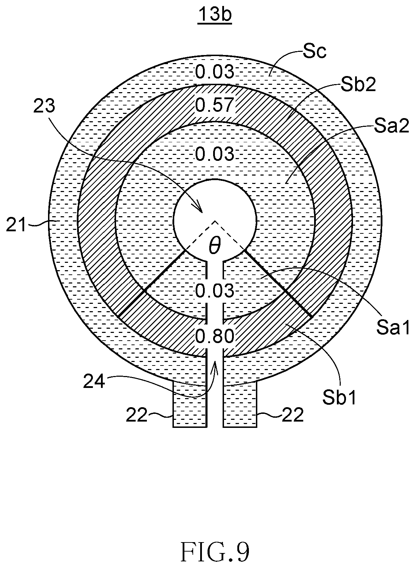

Specifically, as illustrated in FIG. 9, the emissivity of the first inner circumferential area Sa1 was set to 0.03. the emissivity of the first intermediate area Sb1 was to 0.80, the emissivity of the second inner circumferential area Sa2 was to 0.03. the emissivity of the second intermediate area Sb2 was to 0.57, and the emissivity of the outer circumferential area Sc was to 0.03.

The first inner circumferential area Sa1, second inner circumferential area Sa2, and outer circumferential area Sc were each formed as a polished surface, while the first intermediate area Sb1 and second intermediate area Sb2 were each formed as a black plated surface so as to enhance the emissivity. Since the first and second inner circumferential areas Sa1 and Sa2 have the same emissivity, the angle θ defining the boundary between the first and second inner circumferential areas Sa1 and Sa2 has no special meaning.

The emissivities of the areas were thus defined, and the angle θ defining the slit vicinity area was changed to six values (0°: there is no first intermediate area Sb1, 20°, 40°, 80°, 120°, and 360° : there is no second intermediate area Sb2) to prepare six induction heating coils. The above six induction heating coils were used to grow the silicon single crystals 4 each having a diameter of about 200 mm according to the FZ method. Thereafter, the resistivities of silicon wafers cut from the respective silicon single crystals 4 were measured by a four-point probe method, and the in-plane distribution of each resistivity was evaluated. The results are shown in Table 1.

**[Table 1]**

| Angle θ (deg.) defining the slit vicinity area | Feature of the resistivity distribution |
|---|---|
| 0 | The resistivity increased at the wafer outer circumferential portion. |
| 20 | The resistivity slightly increased at the wafer outer circumferential portion. |
| 40 | The resistivity was flat at the wafer outer circumferential portion. |
| 80 | The resistivity was nearly flat at the wafer outer circumferential portion. |
| 120 | The resistivity had a large variation at the wafer outer circumferential portion. |
| 360 | The resistivity increased at the wafer outer circumferential portion. |

As shown in Table 1, the resistivity exhibited the smallest variation when the angle θ of the slit vicinity area was 40°, and the resistivity distribution at the wafer outer circumferential portion became flat. Conversely, the resistivity exhibited a large variation when the angle θ of the slit vicinity area was 120°. When the angle θ was 0° and 360°, the resistivity distribution at the wafer outer circumferential portion was directed upward.

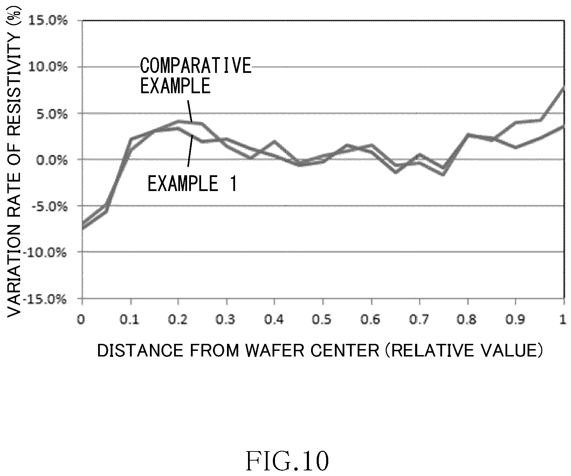

FIG. 10 is a graph illustrating a change in the resistivity distribution in the silicon wafer. The horizontal axis indicates the distance (relative value) from the wafer center, and the vertical axis indicates the variation rate (%) of the resistivity.

As illustrated in FIG. 10, a conventional (comparative example) induction heating coil having unadjusted emissivity distribution exhibited resistivity distribution having a large rise at the wafer outer circumferential portion. On the other hand, the induction heating coil 13 according to Example 1 having adjusted emissivity distribution exhibited a resistivity distribution having a suppressed rise at the wafer outer circumferential portion.

### <Example 2>

Then, to further improve the resistivity distribution at the wafer center portion, out of the five areas on the lower surface 13b of the induction heating coil 13, the second inner circumferential area Sa2 was adjusted in terms of emissivity ε. This was done for breaking the symmetry of the temperature distribution to generate convection.

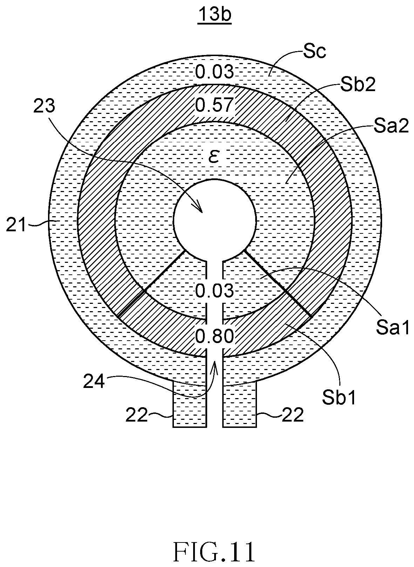

Specifically, as illustrated in FIG. 11, four induction heating coils in which the emissivities ε of the second inner circumferential area Sa2 were set respectively to 0.03, 0.1, 0.3, and 0.5 were prepared. The above four induction heating coils were used to grow the silicon single crystals 4 using the FZ method. Thereafter, the resistivities of silicon wafers cut from the respective silicon single crystals 4 were measured by a four-point probe method, and the in-plane distribution of each resistivity was evaluated. The results were shown in Table 2.

**[Table 2]**

| Emissivity ε of the second inner circumferential area Sa2 | Feature of the resistivity distribution |
|---|---|
| 0.03 | The resistivity was flat at the wafer outer circumferential portion, and decreased at the wafer center portion. |
| 0.10 | The resistivity was flat at the wafer outer circumferential portion, and does not decreased at the wafer center portion. |
| 0.20 | The resistivity was flat at the wafer outer circumferential portion, and increased at the wafer center portion. |
| 0.30 | The resistivity was flat at the wafer outer circumferential portion, and had a variation at the wafer center portion. |
| 0.50 | The resistivity had a large variation as a whole. |
| 0.60 or more | It was difficult to hold the silicon melt and impossible to growing crystal. |

As shown in Table 2, the resistivity distribution at the wafer outer circumferential portion became flat when the emissivity ε of the second inner circumferential area Sa2 was 0.03; however, the resistivity was reduced at the wafer center portion. When the emissivity ε was 0.1, the resistivity distribution at the wafer center portion became flat, and the resistivity at the wafer center portion was not reduced. When the emissivity ε was 0.3, the resistivity distribution at the wafer center portion had a large variation. When the emissivity ε was 0.5, the resistivity distribution had a large variation as a whole. When the emissivity ε was 0.6 or more, a heat removal effect became excessively large, thus making it difficult to hold the silicon melt.

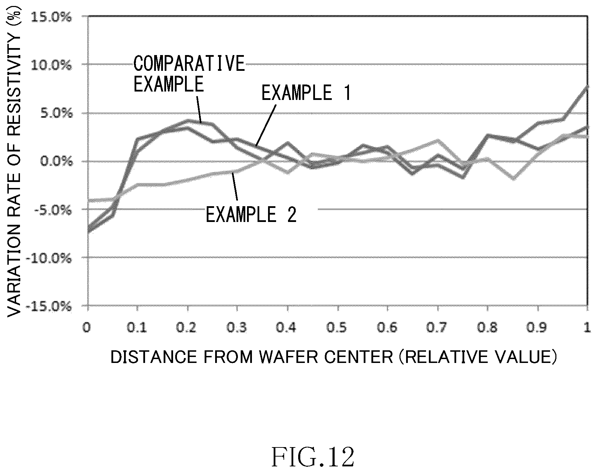

FIG. 12 is a graph illustrating a change in the resistivity distribution in the silicon wafer. The horizontal axis indicates the distance (relative value) from the wafer center, and the vertical axis indicates the variation rate (%) of the resistivity.

As illustrated in FIG. 12, in the induction heating coil 13 according to Example 2 in which the emissivity ε of the second inner circumferential area Sa2 was set to 0.1, the reduction in the resistivity at the wafer center portion was smaller than in Example 1 (ε = 0.03), whereby a variation in the in-plane resistivity distribution was further reduced.

### [Reference Signs List]

- 1: a single crystal manufacturing apparatus
- 2: raw material rod
- 3: seed crystal
- 4: silicon single crystal
- 4a: tapered section
- 4b: straight body section
- 5: molten zone
- 5m: Marangoni convection
- 10: reaction furnace
- 11: upper shaft
- 12: lower shaft
- 13: induction heating coil
- 13a: upper surface of the induction heating coil
- 13b: lower surface of the induction heating coil
- 14: single crystal weight supporter
- 15: gas doping apparatus
- 15a: gas cylinder
- 15b: flow rate controller
- 15c: gas nozzle
- 16: raw material holder
- 17: seed crystal holder
- 21: coil conductor
- 22: terminal electrode
- 23: opening
- 24: slit
- Sa: inner circumferential area
- Sa1: first inner circumferential area
- Sa2: second inner circumferential area
- Sb: intermediate area
- Sb1: first intermediate area
- Sb2: second intermediate area
- Sc: outer circumferential area
- Sc1: first outer circumferential area
- Sc2: second outer circumferential area
- Sc3: third outer circumferential area

## Claims

1. An induction heating coil (13) suitable for manufacturing a silicon single crystal using an FZ method, comprising:
a coil conductor (21) formed of a substantially ring-shaped conductor plate; and
a pair of terminal electrodes (22) provided at one end and the other end of the coil conductor (21) so as to be adjacent in the circumferential direction of the coil conductor (21), wherein
the coil conductor (21) has an opening (23) formed at the center portion thereof and a slit (24) that radially extends from the opening (23) to circumferentially separate connection positions of the pair of terminal electrodes (22) from each other,
**characterized in that**
at least the lower surface of the coil conductor (21) is sectioned into a plurality of areas (Sa, Sb, Sc), and
the plurality of areas (Sa, Sb, Sc) have different emissivities.

2. The induction heating coil (13) according to claim 1, wherein the coil conductor (21) is radially sectioned into the plurality of areas (Sa, Sb, Sc).

3. The induction heating coil (13) according to claim 1 or 2, wherein
the lower surface of the coil conductor (21) has
an inner circumferential area (Sa) adjacent to the opening,
an intermediate area (Sb) positioned radially outside the inner circumferential area (Sa), and
an outer circumferential area (Sc) positioned radially outside the intermediate area (Sb).

4. The induction heating coil (13) according to claim 3, wherein
the emissivity of the intermediate area (Sb) is higher than those of the inner circumferential area (Sa) and outer circumferential area (Sc).

5. The induction heating coil (13) according to claims 4, wherein
the emissivity of the inner circumferential area (Sa) is equal to or higher than that of the outer circumferential area (Sc).

6. The induction heating coil (13) according to claim 4 or 5, wherein
the emissivity of the inner circumferential area (Sa) is 0.03 or more and 0.3 or less,
the emissivity of the intermediate area (Sb) is 0.5 or more and 0.8 or less and
the emissivity of the outer circumferential area (Sc) is 0.03 or more and 0.1 or less.

7. The induction heating coil (13) according to any one of claims 1 to 6, wherein
the coil conductor (21) is circumferentially sectioned into the plurality of areas (Sa1, Sa2, Sb1, Sb2).

8. The induction heating coil (13) according to any one of claims 3 to 5, wherein
the inner circumferential area (Sa) has a first inner circumferential area (Sa1) adjacent to the slit (24) and a second inner circumferential area (Sa2) further away from the slit (24) than the first inner circumferential area (Sa1), and
the intermediate area (Sb) has a first intermediate area (Sb1) adjacent to the slit (24) and a second intermediate area (Sb2) further away from the slit (24) than the first intermediate area (Sb1).

9. The induction heating coil (13) according to claim 8, wherein
the first inner circumferential area (Sa1) is an area within an angle range of 20° or more and 80° or less around the slit (24),
the second inner circumferential area (Sa2) is an area obtained by excluding the first inner circumferential area (Sa1) from the inner circumferential area (Sa),
the first intermediate area (Sb1) is an area within an angle range of 20° or more and 80° or less around the slit (24), and
the second intermediate area (Sb2) is an area obtained by excluding the first intermediate area (Sb1) from the intermediate area (Sb).

10. The induction heating coil (13) according to claim 8 or 9, wherein
the emissivity of the second inner circumferential area (Sa2) is equal to or higher than that of the first inner circumferential area (Sa1), and
the emissivity of the first intermediate area (Sb1) is higher than that of the second intermediate area (Sb2).

11. The induction heating coil (13) according to claim 10, wherein
the emissivity of the first inner circumferential area (Sa1) is 0.03 or more and 0.1 or less, and
the emissivity of the second inner circumferential area (Sa2) is 0.03 or more and 0.3 or less.

12. The induction heating coil (13) according to claim 10 or 11, wherein
the emissivity of the first intermediate area (Sb1) is 0.6 or more and 0.8 or less, and
the emissivity of the second intermediate area (Sb2) is 0.5 or more and less than 0.6.

13. The induction heating coil (13) according to any one of claims 1 to 12, wherein
the lower surface of the coil conductor (21) forms a slope inclined upward toward the coil center.

14. The induction heating coil (13) according to any one of claims 1 to 13, wherein
the upper surface of the coil conductor (21) form a slope inclined downward toward the coil center.

15. The induction heating coil (13) according to any one of claims 1 to 14, wherein
the emissivity is set by changing the surface roughness of the coil conductor (21).

16. The induction heating coil (13) according to any one of claims 1 to 15, wherein
the emissivity is set by forming a coating to cover the surface of the coil conductor (21).

17. A silicon single crystal manufacturing apparatus (1) comprising:
a reaction furnace (10) suitable for accommodating a raw material rod (2) and a silicon single crystal (4) grown on a seed crystal (3);
an upper shaft (11) that rotatably and vertically movably is able to support the raw material rod (2);
a lower shaft (12) that rotatably and vertically movably is able to support the seed crystal (3); and
the induction heating coil (13) according to any one of claims 1 to 16 that is able to heat the lower end portion of the raw material rod (2) to form a molten zone (5).

18. A manufacturing method of a silicon single crystal (4) by FZ method, **characterized in that** a raw material rod (2) for the silicon single crystal (4) is heated and melted by the induction heating coil (13) according to any one of claims 1 to 16.

19. The manufacturing method according to claim 18, wherein
the lower surface of the coil conductor (21) has
an inner circumferential area (Sa) adjacent to the opening, an intermediate area (Sb) positioned radially outside the inner circumferential area (Sa), and
an outer circumferential area (Sc) positioned radially outside the intermediate area (Sb),
a radius of the raw material rod (2) is defined as R,
a radius of the coil conductor (21) is 1.5R or more,
the inner circumferential area (Sa) is an area of less than 0.8R from the coil center in the radial direction,
the intermediate area (Sb) is an area of 0.8R or more and less than 1.2R from the coil center in the radial direction and the outer circumferential area (Sc) is an area of 1.2R or more from the coil center in the radial direction.

## Patentansprüche

1. Induktionsheizspule (13), die zur Herstellung eines Siliziumeinkristalls unter Verwendung eines FZ-Verfahrens geeignet ist, umfassend:
einen Spulenleiter (21), der aus einer im Wesentlichen ringförmigen Leiterplatte gebildet ist; und
ein Paar Anschlusselektroden (22), die an einem Ende und dem anderen Ende des Spulenleiters (21) so vorgesehen sind, dass sie in der Umfangsrichtung des Spulenleiters (21) benachbart sind, wobei
der Spulenleiter (21) eine Öffnung (23), die an seinem Mittelabschnitt gebildet ist, und einen Schlitz (24) der sich radial von der Öffnung (23) erstreckt, aufweist, um Verbindungspositionen des Paars Anschlusselektroden (22) in Umfangsrichtung voneinander zu trennen,
**dadurch gekennzeichnet, dass**
mindestens die untere Oberfläche des Spulenleiters (21) in eine Vielzahl von Bereichen (Sa, Sb, Sc) unterteilt ist, und
die Vielzahl von Bereichen (Sa, Sb, Sc) unterschiedliche Emissionsgrade aufweisen.

2. Induktionsheizspule (13) nach Anspruch 1, wobei der Spulenleiter (21) radial in die Vielzahl von Bereichen (Sa, Sb, Sc) unterteilt ist.

3. Induktionsheizspule (13) nach Anspruch 1 oder 2, wobei
die untere Oberfläche des Spulenleiters (21) Folgendes aufweist:
einen inneren Umfangsbereich (Sa) benachbart zu der Öffnung,
einen Zwischenbereich (Sb), der radial außerhalb des inneren Umfangsbereichs (Sa) positioniert ist, und
einen äußeren Umfangsbereich (Sc), der radial außerhalb des Zwischenbereichs (Sb) positioniert ist.

4. Induktionsheizspule (13) nach Anspruch 3, wobei
der Emissionsgrad des Zwischenbereichs (Sb) höher als jener des inneren Umfangsbereichs (Sa) und des äußeren Umfangsbereichs (Sc) ist.

5. Induktionsheizspule (13) nach Anspruch 4, wobei
der Emissionsgrad des inneren Umfangsbereichs (Sa) gleich oder höher als jener des äußeren Umfangsbereichs (Sc) ist.

6. Induktionsheizspule (13) nach Anspruch 4 oder 5, wobei
der Emissionsgrad des inneren Umfangsbereichs (Sa) 0,03 oder mehr und 0,3 oder weniger beträgt,
der Emissionsgrad des Zwischenbereichs (Sb) 0,5 oder mehr und 0,8 oder weniger beträgt und
der Emissionsgrad des äußeren Umfangsbereichs (Sc) 0,03 oder mehr und 0,1 oder weniger beträgt.

7. Induktionsheizspule (13) nach einem der Ansprüche 1 bis 6, wobei
der Spulenleiter (21) in Umfangsrichtung in die Vielzahl von Bereichen (Sa1, Sa2, Sb1, Sb2) unterteilt ist.

8. Induktionsheizspule (13) nach einem der Ansprüche 3 bis 5, wobei
der innere Umfangsbereich (Sa) einen ersten inneren Umfangsbereich (Sa1) benachbart zu dem Schlitz (24) und einen zweiten inneren Umfangsbereich (Sa2) weiter weg von dem Schlitz (24) als der erste innere Umfangsbereich (Sa1) aufweist, und
der Zwischenbereich (Sb) einen ersten Zwischenbereich (Sb1) benachbart zu dem Schlitz (24) und einen zweiten Zwischenbereich (Sb2) weiter weg von dem Schlitz (24) als der erste Zwischenbereich (Sb1) aufweist.

9. Induktionsheizspule (13) nach Anspruch 8, wobei
der erste innere Umfangsbereich (Sa1) ein Bereich innerhalb eines Winkelbereichs von 20° oder mehr und 80° oder weniger um den Schlitz (24) ist,
der zweite innere Umfangsbereich (Sa2) ein Bereich ist, der durch Ausschließen des ersten inneren Umfangsbereichs (Sa1) von dem inneren Umfangsbereich (Sa) erhalten wird,
der erste Zwischenbereich (Sb1) ein Bereich innerhalb eines Winkelbereichs von 20° oder mehr und 80° oder weniger um den Schlitz (24) ist, und
der zweite Zwischenbereich (Sb2) ein Bereich ist, der durch Ausschließen des ersten Zwischenbereichs (Sb1) von dem Zwischenbereich (Sb) erhalten wird.

10. Induktionsheizspule (13) nach Anspruch 8 oder 9, wobei
der Emissionsgrad des zweiten inneren Umfangsbereichs (Sa2) gleich oder höher als jener des ersten inneren Umfangsbereichs (Sa1) ist, und
der Emissionsgrad des ersten Zwischenbereichs (Sb1) höher als jener des zweiten Zwischenbereichs (Sb2) ist.

11. Induktionsheizspule (13) nach Anspruch 10, wobei
der Emissionsgrad des ersten inneren Umfangsbereichs (Sa1) 0,03 oder mehr und 0,1 oder weniger beträgt, und
der Emissionsgrad des zweiten inneren Umfangsbereichs (Sa2) 0,03 oder mehr und 0,3 oder weniger beträgt.

12. Induktionsheizspule (13) nach Anspruch 10 oder 11, wobei
der Emissionsgrad des ersten Zwischenbereichs (Sb1) 0,6 oder mehr und 0,8 oder weniger beträgt, und
der Emissionsgrad des zweiten Zwischenbereichs (Sb2) 0,5 oder mehr und weniger als 0,6 beträgt.

13. Induktionsheizspule (13) nach einem der Ansprüche 1 bis 12, wobei
die untere Oberfläche des Spulenleiters (21) eine Neigung bildet, die nach oben in Richtung der Spulenmitte geneigt ist.

14. Induktionsheizspule (13) nach einem der Ansprüche 1 bis 13, wobei
die obere Oberfläche des Spulenleiters (21) eine Neigung bildet, die nach unten in Richtung der Spulenmitte geneigt ist.

15. Induktionsheizspule (13) nach einem der Ansprüche 1 bis 14, wobei
der Emissionsgrad durch Ändern der Oberflächenrauheit des Spulenleiters (21) eingestellt wird.

16. Induktionsheizspule (13) nach einem der Ansprüche 1 bis 15, wobei
der Emissionsgrad durch Bilden einer Beschichtung um die Oberfläche des Spulenleiters (21) zu bedecken, eingestellt wird.

17. Siliziumeinkristall-Herstellungsvorrichtung (1), umfassend:
einen Reaktionsofen (10), der zur Aufnahme eines Rohmaterialstabs (2) und eines Siliziumeinkristalls (4), der auf einem Impfkristall (3) gewachsen ist, geeignet ist;
eine obere Welle (11), die drehbar und vertikal beweglich in der Lage ist, den Rohmaterialstab (2) zu tragen;
eine untere Welle (12), die drehbar und vertikal beweglich in der Lage ist, den Impfkristall (3) zu tragen; und
die Induktionsheizspule (13) nach einem der Ansprüche 1 bis 16, die in der Lage ist, den unteren Endabschnitt des Rohmaterialstabs (2) zu erwärmen, um eine Schmelzzone (5) zu bilden.

18. Verfahren zur Herstellung eines Siliziumeinkristalls (4) durch ein FZ-Verfahren, **dadurch gekennzeichnet, dass** ein Rohmaterialstab (2) für den Siliziumeinkristall (4) durch die Induktionsheizspule (13) nach einem der Ansprüche 1 bis 16 erwärmt und geschmolzen wird.

19. Herstellungsverfahren nach Anspruch 18, wobei die untere Oberfläche des Spulenleiters (21) Folgendes aufweist:
einen inneren Umfangsbereich (Sa) benachbart zu der Öffnung, einen Zwischenbereich (Sb), der radial außerhalb des inneren Umfangsbereichs (Sa) positioniert ist, und
einen äußeren Umfangsbereich (Sc), der radial außerhalb des Zwischenbereichs (Sb) positioniert ist,
ein Radius des Rohmaterialstabs (2) als R definiert ist,
ein Radius des Spulenleiters (21) 1,5 R oder mehr beträgt, der innere Umfangsbereich (Sa) ein Bereich von weniger als 0,8 R von der Spulenmitte in der radialen Richtung ist,
der Zwischenbereich (Sb) ein Bereich von 0,8 R oder mehr und weniger als 1,2 R von der Spulenmitte in der radialen Richtung ist und
der äußere Umfangsbereich (Sc) ein Bereich von 1,2 R oder mehr von der Spulenmitte in der radialen Richtung ist.

## Revendications

1. Bobine de chauffage par induction (13) adaptée à la fabrication d'un monocristal de silicium au moyen d'un procédé FZ, comprenant :
un conducteur de bobine (21) constitué d'une plaque conductrice de forme sensiblement annulaire ; et
une paire d'électrodes terminales (22) disposées à une extrémité et à l'autre extrémité du conducteur de bobine (21) de manière à être adjacentes dans la direction circonférentielle du conducteur de bobine (21),
le conducteur de bobine (21) comportant une ouverture (23) formée au niveau de sa partie centrale et une fente (24) qui s'étend radialement depuis l'ouverture (23) jusqu'à des positions de branchement séparées circonférentiellement l'une de l'autre de la paire d'électrodes terminales (22),
**caractérisée en ce que**
au moins la surface inférieure du conducteur de bobine (21) est divisée en une pluralité de zones (Sa, Sb, Sc), et
la pluralité de zones (Sa, Sb, Sc) présentent des émissivités différentes.

2. Bobine de chauffage par induction (13) selon la revendication 1, dans laquelle le conducteur de bobine (21) est divisé radialement en la pluralité de zones (Sa, Sb, Sc).

3. Bobine de chauffage par induction (13) selon la revendication 1 ou 2, dans laquelle
la surface inférieure du conducteur de bobine (21) comporte
une zone circonférentielle interne (Sa) adjacente à l'ouverture,
une zone intermédiaire (Sb) positionnée radialement à l'extérieur de la zone circonférentielle interne (Sa), et
une zone circonférentielle externe (Sc) positionnée radialement à l'extérieur de la zone intermédiaire (Sb).

4. Bobine de chauffage par induction (13) selon la revendication 3, dans laquelle
l'émissivité de la zone intermédiaire (Sb) est supérieure à celles de la zone circonférentielle interne (Sa) et de la zone circonférentielle externe (Sc).

5. Bobine de chauffage par induction (13) selon la revendication 4, dans laquelle
l'émissivité de la zone circonférentielle interne (Sa) est égale ou supérieure à celle de la zone circonférentielle externe (Sc).

6. Bobine de chauffage par induction (13) selon la revendication 4 ou 5, dans laquelle
l'émissivité de la zone circonférentielle interne (Sa) est supérieure ou égale à 0,03 et inférieure ou égale à 0,3,
l'émissivité de la zone intermédiaire (Sb) est supérieure ou égale à 0,5 et inférieure ou égale à 0,8, et
l'émissivité de la zone circonférentielle externe (SC) est supérieure ou égale à 0,03 et inférieure ou égale à 0,1.

7. Bobine de chauffage par induction (13) selon l'une quelconque des revendications 1 à 6, dans laquelle
le conducteur de bobine (21) est divisé circonférentiellement en la pluralité de zones (Sa1, Sa2, Sb1, Sb2).

8. Bobine de chauffage par induction (13) selon l'une quelconque des revendications 3 à 5, dans laquelle
la zone circonférentielle interne (Sa) comporte une première zone circonférentielle interne (Sa1) adjacente à la fente (24) et une deuxième zone circonférentielle interne (Sa2) plus éloignée de la fente (24) que la première zone circonférentielle interne (Sa1), et
la zone intermédiaire (Sb) comporte une première zone intermédiaire (Sb1) adjacente à la fente (24) et une deuxième zone intermédiaire (Sb2) plus éloignée de la fente (24) que la première zone intermédiaire (Sb1).

9. Bobine de chauffage par induction (13) selon la revendication 8, dans laquelle
la première zone circonférentielle interne (Sa1) est une zone à l'intérieur d'une plage angulaire de 20° ou plus et 80° ou moins autour de la fente (24),
la deuxième zone circonférentielle interne (Sa2) est une zone obtenue par exclusion de la première zone circonférentielle interne (Sa1) de la zone circonférentielle interne (Sa),
la première zone intermédiaire (Sb1) est une zone à l'intérieur d'une plage angulaire de 20° ou plus et 80° ou moins autour de la fente (24), et
la deuxième zone intermédiaire (Sb2) est une zone obtenue par exclusion de la première zone intermédiaire (Sb1) de la zone intermédiaire (Sb).

10. Bobine de chauffage par induction (13) selon la revendication 8 ou 9, dans laquelle
l'émissivité de la deuxième zone circonférentielle interne (Sa2) est égale ou supérieure à celle de la première zone circonférentielle interne (Sa1), et
l'émissivité de la première zone intermédiaire (Sb1) est supérieure à celle de la deuxième zone intermédiaire (Sb2).

11. Bobine de chauffage par induction (13) selon la revendication 10, dans laquelle
l'émissivité de la première zone circonférentielle interne (Sa1) est supérieure ou égale à 0,03 et inférieure ou égale à 0,1, et
l'émissivité de la deuxième zone circonférentielle interne (Sa2) est supérieure ou égale à 0,03 et inférieure ou égale à 0,3.

12. Bobine de chauffage par induction (13) selon la revendication 10 ou 11, dans laquelle
l'émissivité de la première zone intermédiaire (Sb1) est supérieure ou égale à 0,6 et inférieure ou égale à 0,8, et
l'émissivité de la deuxième zone intermédiaire (Sb2) est supérieure ou égale à 0,5 et inférieure à 0,6.

13. Bobine de chauffage par induction (13) selon l'une quelconque des revendications 1 à 12, dans laquelle
la surface inférieure du conducteur de bobine (21) forme une pente inclinée vers le haut en direction du centre de la bobine.

14. Bobine de chauffage par induction (13) selon l'une quelconque des revendications 1 à 13, dans laquelle
la surface supérieure du conducteur de bobine (21) forme une pente inclinée vers le bas en direction du centre de la bobine.

15. Bobine de chauffage par induction (13) selon l'une quelconque des revendications 1 à 14, dans laquelle
l'émissivité est réglée par modification de la rugosité de surface du conducteur de bobine (21).

16. Bobine de chauffage par induction (13) selon l'une quelconque des revendications 1 à 15, dans laquelle
l'émissivité est réglée par formation d'un revêtement destiné à recouvrir la surface du conducteur de bobine (21).

17. Appareil de fabrication de monocristaux de silicium (1) comprenant :
un four de réaction (10) adapté à l'accueil d'une tige de matière première (2) et d'un monocristal de silicium (4) que l'on a fait croître sur un germe cristallin (3) ;
un arbre supérieur (11) mobile en rotation et verticalement qui peut soutenir la tige de matière première (2) ;
un arbre inférieur (12) mobile en rotation et verticalement qui peut soutenir le germe cristallin (3) ; et
la bobine de chauffage par induction (13) selon l'une quelconque des revendications 1 à 16 qui peut chauffer la partie d'extrémité inférieure de la tige de matière première (2) pour former une zone fondue (5).

18. Procédé de fabrication d'un monocristal de silicium (4) par le procédé FZ, **caractérisé en ce que**
une tige de matière première (2) pour le monocristal de silicium (4) est chauffée et fondue par la bobine de chauffage par induction (13) selon l'une quelconque des revendications 1 à 16.

19. Procédé de fabrication selon la revendication 18, dans lequel
la surface inférieure du conducteur de bobine (21) comporte
une zone circonférentielle interne (Sa) adjacente à l'ouverture,
une zone intermédiaire (Sb) positionnée radialement à l'extérieur de la zone circonférentielle interne (Sa), et
une zone circonférentielle externe (Sc) positionnée radialement à l'extérieur de la zone intermédiaire (Sb), un rayon de la tige de matière première (2) est défini comme R,
un rayon du conducteur de bobine (21) est égal ou supérieur à 1,5R,
la zone circonférentielle interne (Sa) est une zone à moins de 0,8R du centre de la bobine dans la direction radiale,
la zone intermédiaire (Sb) est une zone à 0,8R ou plus et moins de 1,2R du centre de la bobine dans la direction radiale, et la zone circonférentielle externe (Sc) est une zone à 1,2R ou plus du centre de la bobine dans la direction radiale.
